# EUROPÄISCHE PATENTSCHRIFT

(11) **EP 4 008 018 B1**
(45) Veröffentlichungstag und Bekanntmachung des Hinweises auf die Patenterteilung: **30.10.2024**
(21) Anmeldenummer: 20772235.6
(22) Anmeldetag: 08.09.2020
(51) Int. Cl.: H01H 85/046, H01H 85/175, H01H 85/43, H01H 85/46

(54) **LEITERBAHNSICHERUNG**
CIRCUIT PATH PROTECTION
PROTECTION POUR PISTE CONDUCTRICE

(30) Priorität: 13.09.2019 AT 5016619 U
(43) Veröffentlichungstag der Anmeldung: 08.06.2022
(73) Patentinhaber: Tridonic GmbH & Co. KG, 6851 Dornbirn (AT)
(72) Erfinder: HECHENBERGER, Claus, 6890 Lustenau (AT); BILDSTEIN, Markus, 6850 Dornbirn (AT); KÖNIG, Jakob, 6845 Hohenems (AT)
(74) Vertreter: Rupp, Christian
(86) Internationale Anmeldenummer: PCT/EP2020/075018
(87) Internationale Veröffentlichungsnummer: WO 2021/048090

(56) Entgegenhaltungen:
- WO-A1-2012/084525
- DE-A1- 102016 219 771
- DE-U1- 9 015 208
- US-A- 4 689 597
- US-A1- 2016 111 240

## Beschreibung

Die Erfindung betrifft eine Leiterbahnsicherung zur elektrischen Absicherung von elektrischen Geräten.

### Stand der Technik

Leiterbahnsicherungen sind aus dem Stand der Technik bereits bekannt. Sie sind auf einer Leiterplatte bzw. Platine aufgebracht und haben die Aufgabe im Falle eines anormalen Betriebszustands, wie beispielsweise einem Kurzschluss elektrischer Komponenten der Platine, die elektrische Verbindung zur Spannungsversorgung schnell und zuverlässig zu durchbrechen. Dadurch kann insbesondere weiterer Schaden der Platine bzw. an den sich darauf befindlichen elektrischen Komponenten vermieden werden. Des Weiteren ist es möglich, durch ein frühzeitiges Auslösen der Leiterbahnsicherung ein Auslösen eines Netzschutzschalters zu verhindern.

Durch die Bereitstellung einer Leiterbahnsicherung auf einer Platine ist es zudem möglich eine sonst übliche Feinsicherung zur Absicherung elektrischer oder elektronischer Geräte zu ersetzen.

Die Leiterbahnsicherung weist im Allgemeinen wenigstens einen Leiterbahnabschnitt auf, welcher als Schmelzsicherung bzw. Schmelzleiter ausgeführt ist. Dieser Leiterbahnabschnitt hat dabei im Vergleich zu den anderen Leiterbahnen auf der Platine einen verengten Querschnitt. Der Schmelzleiter wird durch den durch ihn durchfließenden Strom erwärmt und schmilzt oder verdampft, wenn der Bemessungsstrom des Schmelzleiters deutlich überschritten wird, was zu einer Stromkreisunterbrechung führt.

Hierbei ist darauf zu achten, dass ein eventuell auftretender Lichtbogen kontrolliert erlöschen und insbesondere keine anderen Leiterzüge erreichen kann. Insbesondere soll verhindert werden, dass beim Schmelzen oder Verdampfen der Schmelzsicherung auftretendes Plasma ein neues, unter Spannung stehendes Kontaktpaar findet und dadurch unkontrolliert weiterbrennt und somit weiteren Schaden auf der Platine verursacht.

DE 100 05 836 B4 beschreibt eine Leiterplatte für ein elektrisches oder elektronisches Gerät mit einer Leiterplattensicherung, wobei die Leiterplatte einen abzusichernden Leiterzug trägt und wobei der Leiterzug einen Bereich mit reduziertem Querschnitt als Durchbrennbereich aufweist und mit einer nichtleitenden Beschichtung versehen ist.

Der Leiterzug weist zudem wenigstens zwei im Abstand zueinander auf dem Durchbrennbereich angeordnete, in Leiterzuglängsrichtung voneinander beabstandete und zusätzlich zu der Beschichtung vorgesehene Anhäufungen aus nichtleitendem Material auf.

Das Dokument DE 10 2016 219 771 A1 zeigt eine elektronische Baugruppe mit einer Anordnung zur Strombegrenzung. Insbesondere wird eine Durchbrennsicherung auf einer Leiterplatte gezeigt. Ein Durchbrennbereich ist dabei von einer hermetisch abschließenden Abdeckung abgedeckt.

Das Dokument WO 2012/084525 A1 zeigt eine Leiterbahnsicherung. Dabei ist auf einer Leiterplatte eine mäanderförmig verlaufende Leiterbahn erstreckt, welche einen verringerten Querschnitt aufweist, und somit bei Überschreitung eines Nennstroms schmilzt bzw. verdampft. Diese Leiterbahn ist zumindest zum Teil durch eine direkt aufliegende Abdeckung abgedeckt.

Das Dokument DE 90 15 208.5 zeigt eine Schmelzsicherung in Form eines dedizierten Bauelements, welches zur Montage auf Leiterplatten ausgelegt ist. Das Bauelement weist dabei eine Entgasungsöffnung auf.

Das Dokument US 4,689,597 A zeigt ein Betriebsgerät für Leuchten, welches eine Schmelzsicherung zur Strombegrenzung aufweist.

### Aufgabenstellung

Ausgehend von diesem bekannten Stand der Technik ist es Aufgabe der Erfindung, eine kostengünstig zu produzierende Leiterbahnsicherung für eine Leiterplatte bzw. Platine bereitzustellen, welche im Fehlerfall ein gefahrloses und sicheres Abschalten der Stromzufuhr zur Platine ermöglicht und demnach die Betriebssicherheit der Platine verbessert.

Diese Aufgabe wird erfindungsgemäß durch die Merkmale des Anspruchs 1 gelöst. Besonders vorteilhafte Ausführungen der Erfindung sind in den abhängigen Ansprüchen beschrieben.

In einem ersten Aspekt betrifft die vorliegende Erfindung eine Leiterbahnsicherung für ein elektrisches oder elektronisches Gerät, aufweisend einen ersten und zweiten Anschlussbereich, einen zwischen dem ersten und zweiten Anschlussbereich angeordneten, sich nicht linear erstreckenden Durchbrennbereich, und einen zusammenhängenden Abdeckungsbereich, welcher wenigstens jeweils teilweise über dem ersten und zweiten Anschlussbereich und dem Durchbrennbereich angeordnet ist, wobei der Durchbrennbereich und der Abdeckungsbereich derart zueinander angeordnet sind, dass wenigstens ein Auslösebereich des Durchbrennbereichs nicht von dem Abdeckungsbereich abgedeckt, aber beidseitig von dem Abdeckungsbereich begrenzt ist. Das Abdeckungselement weist zumindest zwei Seitenwände auf, und ist derart ausgebildet, dass die Seitenwände den Hohlraum nicht vollständig umschließen, so dass in Draufsicht der Leiterbahnsicherung eine Entgasungsöffnung an einer Stirnseite des Abdeckungselementes gebildet wird.

Die vorliegende Erfindung ermöglicht die Bereitstellung einer einfach herstellbaren, aber gleichzeitig sehr effizienten Leiterbahnsicherung, mit Hilfe derer die Betriebssicherheit eines elektrischen bzw. elektronischen Geräts erhöht wird.

In einer vorteilhaften Ausführungsform der Erfindung weist der Durchbrennbereich in Draufsicht einen wenigstens teilweise gebogenen oder teilweise zickzackförmigen Verlauf auf. Dieser gebogene oder zickzackförmige Verlauf des Durchbrennbereichs erstreckt sich dabei vorzugsweise entlang einer Haupterstreckungsrichtung des Durchbrennbereichs. Diese Haupterstreckungsrichtung des Durchbrennbereichs entspricht vorzugsweise einer direkten Verbindung des ersten und zweiten Anschlussbereichs der Leiterbahnsicherung in Draufsicht. Der gebogene oder zickzackförmige Verlauf des Durchbrennbereichs erstreckt sich vorzugweise zu beiden Seiten der Haupterstreckungsrichtung des Durchbrennbereichs zu gleichem Ausmaß.

In einer weiteren bevorzugten Ausführungsform kann der gebogene oder zickzackförmige Verlauf auch derart ausgeprägt sein, dass dieser Verlauf des Durchbrennbereichs sich zu einer Seite der Haupterstreckungsrichtung des Durchbrennbereichs weiter erstreckt, als zu einer gegenüberliegenden Seite der Haupterstreckungsrichtung.

Des Weiteren kann der Durchbrennbereich auch einen andersförmigen nicht-linearen Verlauf aufweisen.

Die Herstellungszeit sowie die Herstellungskosten der Leiterbahnsicherung können reduziert werden. Gleichzeitig wird ein zuverlässiger Schutz der Platine mit Hilfe der erfindungsgemäßen Leiterbahnsicherung ermöglicht.

Der Durchbrennbereich der Leiterbahnsicherung ist vorzugsweise ein unverzinnter Kupferleiter, welcher einen gegenüber dem ersten und zweiten Anschlussbereich reduzierten Querschnitt aufweist. Der Durchbrennbereich kann jedoch auch aus einem anderen Material wie beispielsweise Feinsilber gebildet sein. Der Querschnitt des Durchbrennbereichs liegt vorzugsweise zwischen 0,05 und 1 mm.

Im Fall einer Beaufschlagung des Durchbrennbereichs mit einem Strom, der dessen Bemessungsstrom deutlich überschreitet, kommt es zum Verdampfen bzw. Schmelzen des Durchbrennbereichs. Des Weiteren wird durch den Abdeckungselement der Leiterbahnsicherung gewährleistet, dass das dabei entstehende Plasma nicht andere unter Strom stehende Kontaktpaare erreicht.

Auf diese Weise wird eine Leiterbahnsicherung mit definiertem Auslösebereich bereitgestellt, wobei das entstehende Plasma beim Verdampfen des Durchbrennbereichs möglichst gering gehalten wird.

In einem zweiten Aspekt beschreibt die vorliegende Erfindung eine Leiterplatte aufweisend eine Leiterbahnsicherung mit den oben beschriebenen Merkmalen.

Die vorliegende Erfindung ermöglicht demnach die Erhöhung der Betriebssicherheit der Leiterplatte mit einer einfach herstellbaren Leiterbahnsicherung.

In einem weiteren Aspekt beschreibt die vorliegende Erfindung eine Betriebsgerät für Leuchtmittel aufweisend eine erfindungsgemäße Leiterbahnsicherung.

### Ausführungsbeispiele

Vorteilhafte Ausführungsbeispiele der vorliegenden Erfindung sind in den folgenden Figuren darstellt und werden anhand der nachfolgenden Beschreibung näher erläutert.
Fig. 1 zeigt einen schematischen Querschnitt der erfindungsgemäßen Leiterbahnsicherung gemäß einem ersten Ausführungsbeispiel.
Fig. 2 zeigt eine schematische Draufsicht der erfindungsgemäßen Leiterbahnsicherung gemäß einem zweiten Ausführungsbeispiel.
Fig. 3 zeigt eine Leiterplatte eines elektrischen oder elektronischen Geräts aufweisend eine erfindungsgemäße Leiterbahnsicherung.
Figur 4 zeigt eine erfindungsgemäße Ausgestaltung eines Abdeckungselementes.

### Detaillierte Beschreibung der Ausführungsbeispiele

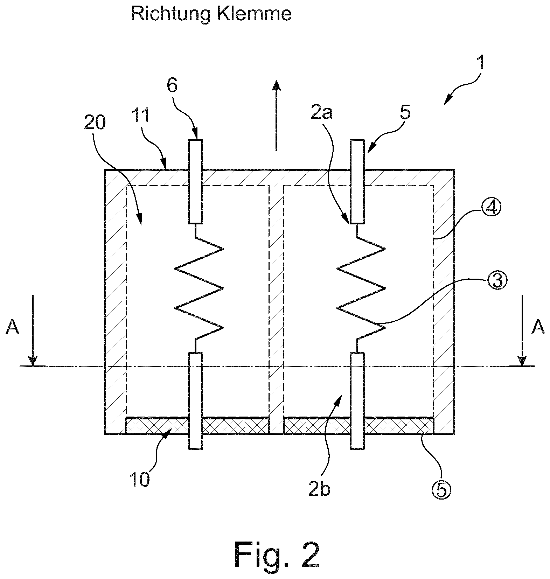

Figur 2 zeigt eine schematische Draufsicht der erfindungsgemäßen Leiterbahnsicherung 1 gemäß einem ersten Ausführungsbeispiel. Die Leiterbahnsicherung 1 ist auf einer Leiterplatte bzw. Platine 20 aufgebracht und weist einen ersten und zweiten Anschlussbereich 2a,2b auf. Die Anschlussbereiche 2a,2b sind in einem Abstand D angeordnet, welcher vorzugsweise zwischen 3 und 15 mm beträgt.

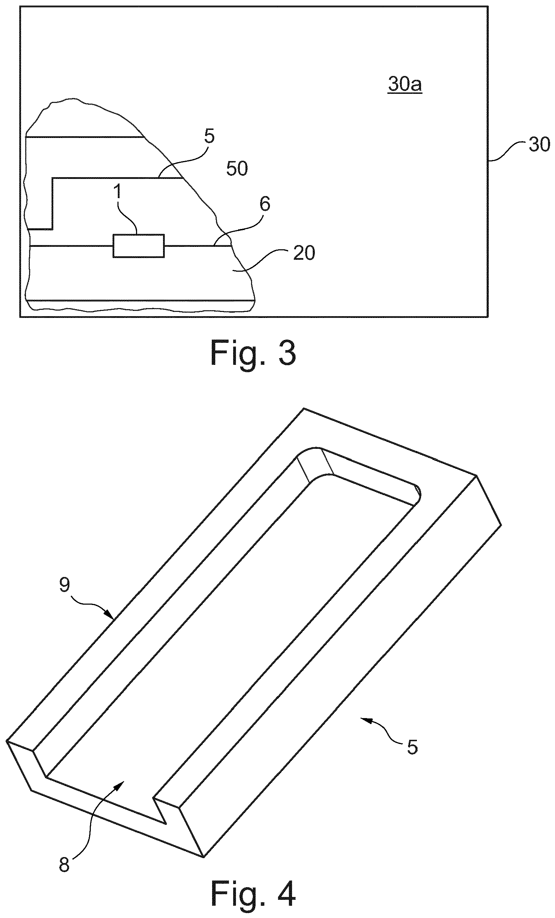

Zwischen dem ersten und zweiten Anschlussbereich 2a,2b ist ein Durchbrennbereich 3 angeordnet, welcher elektrisch mit diesen kontaktiert ist. Der Durchbrennbereich weist einen Querschnitt d' auf, welcher gegenüber dem Querschnitt d des ersten und zweiten Anschlussbereichs 2a,2b verringert ist. Vorteilhafterweise ist der Querschnitt d' des Durchbrennbereichs 3 auch gegenüber den übrigen sich auf der Platine 20 befindlichen Leiterbahnen 5,6 (siehe Figur 3) verringert.

Der Querschnitt d' des Durchbrennbereichs 3 ist dabei derart dimensioniert, dass der Durchbrennbereich bei einer Überschreitung des Bemessungsstroms der Leiterbahnsicherung 1 verdampft bzw. schmilzt.

Der Durchbrennbereich 3 ist vorzugsweise nicht-linear zwischen dem ersten und zweiten Anschlussbereich 2a,2b angeordnet. In einer bevorzugten Ausführungsform weist der Durchbrennbereich 3 einen zickzackförmigen Verlauf auf, welcher sich entlang einer Haupterstreckungsrichtung Z erstreckt.

Die Haupterstreckungsrichtung Z entspricht dabei vorzugsweise der direkten bzw. der kürzesten Verbindung des ersten und zweiten Anschlussbereichs 2a,2b.

Der zickzackförmige Verlauf des Durchbrennbereichs 3 erstreckt sich vorzugsweise zu gleichem Ausmaß Y, Y' zu beiden Seiten der Haupterstreckungsrichtung Z. Es ist jedoch auch möglich, dass sich der zickzackförmige Verlauf zu unterschiedlichem Ausmaß Y,Y' von der Haupterstreckungsrichtung Z erstreckt.

Figur 2 zeigt eine schematische Draufsicht auf die erfindungsgemäße Leiterbahnsicherung 1 für ein elektrisches oder elektronisches Gerät, aufweisend einen ersten und zweiten Anschlussbereich 2a,2b, einen zwischen dem ersten und zweiten Anschlussbereich 2a,2b angeordneten, sich linear oder nicht linear erstreckenden Durchbrennbereich 3, und einem Abdeckungselement 5 mit zumindest zwei Seitenwänden 9 und einer Abdeckfläche 8. Das Abdeckungselement 5 ist über dem ersten und zweiten Anschlussbereich 2a, 2b und dem Durchbrennbereich 3 angeordnet. Der Durchbrennbereich 3 und der Abdeckungselement 5 sind derart zueinander angeordnet, dass die Fläche der Abdeckfläche 8 den Durchbrennbereich 3 abdeckt und durch die Höhe der Seitenwänden 9 zwischen dem Durchbrennbereich 3 und der Abdeckfläche 8 ein Hohlraum 7 gebildet wird.

Der Durchbrennbereich 3 kann in Draufsicht einen linearen Verlauf, einen zickzackförmigen Verlauf oder einen wenigstens teilweise gebogenen oder eckigen Verlauf aufweisen.

Die Seitenwände 9 sind parallel zu einer Haupterstreckungsrichtung des Durchbrennbereichs 3 angeordnet.

Der Durchbrennbereich 3 weist einen gegenüber dem ersten und zweiten Anschlussbereich 2a, 2b reduzierten Querschnitt d' auf.

Das Abdeckungselement 5 mit den zumindest zwei Seitenwänden 9 ist vorzugsweise homogen ausgebildet und weist eine konstante Dicke t auf.

Das Abdeckungselement 5 ist derart ausgebildet, dass die Seitenwände 9 den Hohlraum 7 nicht vollständig umschließen, so dass in Draufsicht der Leiterbahnsicherung eine Entgasungsöffnung 10 an einer Stirnseite des Abdeckungselementes 5 gebildet wird.

Das Abdeckungselement 5 kann eine gegenüber der Entgasungsöffnung 10 angeordnete Begrenzungswand 11 aufweisen, die derart angeordnet ist, dass sie die beiden Seitenwände 9 an einem Ende des Abdeckungselementes 5 verbindet.

Der Durchbrennbereich 3 kann ein unverzinnter Kupferleiter sein.

Die Abdeckfläche 8 kann auch eine durch Wellenform oder Rippen vergrößerte Oberfläche aufweisen

Das Abdeckungselement 5 kann auch rund oder oval ausgeführt sein, und somit Seitenwände in einer abgerundeten Form aufweisen.

Es kann ein Steg in der Entgasungsöffnung 10 des Abdeckungselementes 5 angeordnet sein. Ein derartiger Steg kann ein Verschließen der Entgasungsöffnung 10 beim Lötprozess bei der Bestückung des Betriebsgerätes verhindern.

Somit kann gemäß der Erfindung eine Leiterplatte 20 aufweisend eine Leiterbahnsicherung 1 gemäß den oben angeführten Merkmalen ausgebildet sein.

Das Abdeckungselement 5 kann mit der Unterseite der Seitenwände 9 an der Leiterplatte 20 befestigt sein und ist vorzugsweise mittels eines Verbindungselementes 4 verbunden.

Das Verbindungselement 4 kann ein Balken oder Streifen aus nichtleitendem Material, vorzugsweise SMD-Kleber oder Lötstopplack sein.

Das Verbindungselement 4 kann mit Hilfe einer Schablone auftragbar sein.

Ein Verdampfen bzw. Schmelzen unter Entstehung von Plasma des restlichen Durchbrennbereichs 3 wird durch das Abdeckungselement 5 vermieden, welches die darunterliegenden Leiterbahnen 6 kühlt.

Der Querschnitt d" des wenigstens einen Auslösebereichs 3a ist vorzugsweise gleich dem Querschnitt d' des Durchbrennbereichs 3.

In einer alternativen Ausführungsform weist der wenigstens eine Auslösebereich 3a einen gegenüber dem Querschnitt d' des Durchbrennbereichs 3 weiter reduzierten Querschnitt d" auf.

In einer bevorzugten Ausführungsform weist die Leiterbahnsicherung 1 mehrere Auslösebereiche 3a auf. Vorzugsweise sind drei Auslösebereiche 3a,3b,3c vorhanden, welche jeweils von dem Abdeckungselement 5 zu beiden Seiten begrenzt sind.

Das Abdeckungselement 5 ist linear zwischen dem ersten und zweiten Anschlussbereich 2a, 2b und damit der Haupterstreckungsrichtung Z des Durchbrennbereichs 3 folgend auf der Platine 20 angeordnet. Das Abdeckungselement 5 ist dabei von konstanter Breite B. Die Breite B ist vorzugsweise kleiner als die Summe der Erstreckungslängen Y und Y' des Durchbrennbereichs 3, welche rechtwinklig bezüglich der Haupterstreckungsrichtung Z angeordnet sind.

Das Abdeckungselement 5 ist ferner vorzugsweise mittig bezüglich der Haupterstreckungsrichtung Z auf der Platine 20 angeordnet.

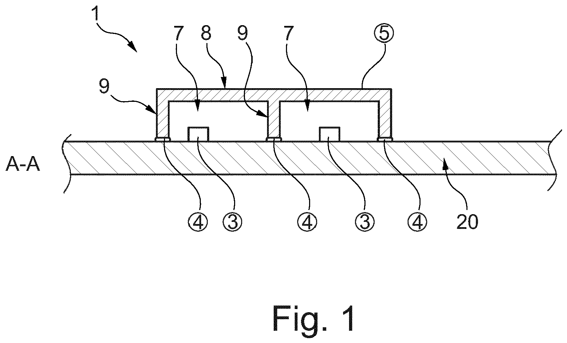

Figur 1 zeigt einen schematischen Querschnitt an der Schnittlinie A-A der erfindungsgemäßen Leiterbahnsicherung gemäß einem zweiten und dritten Ausführungsbeispiel. Dieses Ausführungsbeispiel entspricht im Wesentlichen dem Ausführungsbeispiel gemäß Figur 2 mit der Schnittlinie A-A, wobei die gleichen Bauteile mit gleichen Bezugszeichen versehen sind.

Gemäß dem in Figur 2 gezeigten Ausführungsbeispiel weist der Durchbrennbereich 3 einen wenigstens teilweise einen eckigen bzw. rechtwinkligen Verlauf auf. Der wenigstens eine Auslösebereich 3a ist hierbei wiederum durch den Abdeckungselement 5 zu beiden Seiten begrenzt.

Die erfindungsgemäße Leiterbahnsicherung kann somit vereinfacht hergestellt werden. Hierbei werden die Anschlussbereiche 2a,2b, welche vorzugsweise mit weiteren Leiterbahnen der Platine 20 elektrisch verbunden sind, zusammen mit diesen auf die Platine 20 aufgetragen. In dem gleichen oder in einem direkt darauf folgenden Verfahrensschritt kann die den Durchbrennbereich 3 bildende Leiterbahn zwischen den ersten und zweiten Anschlussbereich 2a,2b auf die Platine 20 aufgebracht werden.

Unter "Aufbringen" der Leiterbahnen auf die Leiterplatte 20 ist insbesondere auch ein Ätzen der jeweiligen Leiterbahn aus einer dünnen sich auf der Leiterplatte befindlichen Kupferschicht zu verstehen.

In einem anschließenden Verfahrensschritt kann das Verbindungselementes 4 auf der Leiterplatte 20 aufgetragen werden. Dabei wird der Abdeckungsbereich 4 vorzugsweise mit Hilfe einer Schablone aufgetragen. In einem gleichzeitigen Schritt kann durch Rakeln oder Dispensen eine gleichmäßige Dicke des Verbindungselementes 4 erzielt werden. In einem weiteren Schritt wird das Abdeckungselement 5 aufgebracht.

In einer alternativen Variante könnte das Verbindungselement 4 auch durch Lötzinn gebildet werden und das Abdeckungselement 5 beispielsweise während eines Reflow-Lötprozesses befestigt werden.

Wichtig ist vor allem, dass die Entgasungsöffnung 10 erhalten wird.

Das Abdeckungselement 5 kann somit als Korrosions- oder Berührungsschutz dienen.

Das Verbindungselementes 4 ist wie in Figur 2 ersichtlich filmartig ausgeprägt und dabei vorzugsweise aus einem nichtleitenden Material, beispielsweise Lötstopplack oder SMD-Kleber.

Der Verbindungselementes 4 und/oder Abdeckungselement 5 können zudem lichtbogenlöschende Substanzen enthalten.

Wenn das Verbindungselement 4 durch SMD-Kleber gebildet ist, erfolgt der Auftrag des Verbindungselementes 4 vorzugsweise in einem Schritt mit den auf die Platine 20 aufzutragenden Klebepunkten während der Herstellung der Platine.

Das selektive Auftragen des Verbindungselementes 4 kann somit in einem Schritt mit dem Auftrag der Klebepunkte auf die Platine 20 erfolgen.

Es ist somit ein vereinfachter Herstellungsprozess der Leiterplatte 20 möglich.

Figur 3 zeigt ein Vorschaltgerät 30 für Leuchtmittel aufweisend eine Platine 20, auf welcher die die Betriebsgerät des Leuchtmittels bildenden Leiterbahnen 50,6 aufgebracht sind. Das Vorschaltgerät 30 weist dabei eine erfindungsgemäße Leiterbahnsicherung 1 auf.

Die Platine 20 befindet sich dabei im Inneren eines Gehäuses 30a des Geräts 30. Die Leiterbahnen 50,6 stehen in Kontakt mit einer nicht dargestellten externen Stromversorgung, zum Beispiel ein 230V Netz.

Die Leiterbahn 6 ist mit einer erfindungsgemäßen Leiterbahnsicherung 1 elektrisch kontaktiert. Hierdurch wird eine elektrische Absicherung der Leiterbahn 6 und damit des elektrischen Geräts 30 ermöglicht.

Ein in der Schaltung entstehender Kurzschluss oder ein anormaler Betriebszustand, der zu einem den Bemessungsstrom der Leiterbahnsicherung 1 deutlich übersteigenden Strom in den Leiterbahnen 50, 6 führt, kann somit sicher durch die Leiterbahnsicherung 1 unterbrochen werden.

Vorzugsweise ist die Leiterbahnsicherung derart in dem Betriebsgerät angeordnet, dass die Entgasungsöffnung 10 in der entgegengesetzten Richtung zu den Klemmen für die Kontaktierung des Netzanschlusses des Betriebsgerätes angeordnet ist, so dass eine Entgasung der Leiterbahnsicherung in Richtung des Inneren des Betriebsgerätes erfolgt. Typischerweise ist die Leiterbahnsicherung innerhalb des Gehäuses 30a in der Nähe der Klemmen für die Kontaktierung des Netzanschlusses des Betriebsgerätes angeordnet. Vorzugsweise ist die Leiterbahnsicherung derart in dem Betriebsgerät mit dem Gehäuse 30a angeordnet, dass die Entgasungsöffnung 10 in Richtung des Inneren des Gehäuses 30a gerichtet ist, also in der entgegengesetzten Richtung zu den Klemmen für die Kontaktierung des Netzanschlusses des Betriebsgerätes oder anderer Öffnungen an den Seiten des Gehäuses 30a.

Ein Auslösen der Leiterbahnsicherung erfolgt im Fehlerfall, also wenn beispielsweise ein Strom von 160 A DC bei den Netzanschlüssen des Betriebsgerätes eingespeist wird. Dieser hohe Strom führt dazu, dass das Leitermaterial der Leiterbahnsicherung explosionsartig Verbrennt und sich ein Plasma bildet. Die frei werdende Energie breitet sich dahin aus, wo sie auf keinen oder nur einen geringen Widerstand trifft.

Das Abdeckungselement 5, welches über dem Durchbrennbereich 3 angeordnet ist, verhindert jedoch, dass das sich die Energie unkontrolliert ausbreitet. Durch die Entgasungsöffnung 10 ist das Abdeckungselement 5 in einer Richtung offen. Die Größe und Position der Entgasungsöffnung 10 kann abhängig von Größe und Form der Leiterbahnsicherung individuell bestimmt werden. Mittels einer entsprechenden Ausrichtung des Abdeckungselementes 5 mit der Entgasungsöffnung 10 innerhalb des Gehäuses 30a kann die Richtung der von der Leiterbahnsicherung freigesetzten Energie gewählt werden und somit kann die Energie in einen Bereich des Gehäuses 30a geleitet werden, in dem sie ausreichend absorbiert werden kann, bevor sie in einen Außenbereich des Gehäuses 30a tritt.

Figur 4 zeigt eine beispielhafte Ausgestaltung eines Abdeckungselementes 5. Beispielsweise kann das Abdeckungselement 5 nur für einen einzelnen Durchbrennbereich 3 und somit eine einzelne Leiterbahn 6 vorgesehen sein, wobei mehrere einzelne Abdeckungselemente 5 für mehrere einzelne Durchbrennbereiche 3 vorgesehen sein können.

## Patentansprüche

1. Leiterbahnsicherung (1) für ein elektrisches oder elektronisches Gerät, aufweisend einen ersten und zweiten Anschlussbereich (2a,2b), einen zwischen dem ersten und zweiten Anschlussbereich (2a,2b) angeordneten, sich linear oder nicht linear erstreckenden Durchbrennbereich (3), und einem Abdeckungselement (5) mit zumindest zwei Seitenwänden (9) und einer Abdeckfläche (8), welches über dem ersten und zweiten Anschlussbereich (2a,2b) und dem Durchbrennbereich (3) angeordnet ist, wobei der Durchbrennbereich (3) und der Abdeckungselement (5) derart zueinander angeordnet sind, dass die Fläche des Abdeckfläche (8) den Durchbrennbereich (3) abdeckt und durch die Höhe der Seitenwänden (9) zwischen dem Durchbrennbereich (3) und der Abdeckfläche (8) ein Hohlraum (7) gebildet wird, **dadurch gekennzeichnet,**
**dass** das Abdeckungselement (5) derart ausgebildet ist, dass die Seitenwände (9) den Hohlraum (7) nicht vollständig umschließen, so dass in Draufsicht der Leiterbahnsicherung eine Entgasungsöffnung (10) an einer Stirnseite des Abdeckungselementes (5) gebildet wird.

2. Leiterbahnsicherung (1) nach Anspruch 1, **dadurch gekennzeichnet, dass** der Durchbrennbereich (3) in Draufsicht einen zickzackförmigen Verlauf aufweist.

3. Leiterbahnsicherung (1) nach Anspruch 1, **dadurch gekennzeichnet, dass** der Durchbrennbereich (3) in Draufsicht einen wenigstens teilweise gebogenen oder eckigen Verlauf aufweist.

4. Leiterbahnsicherung (1) nach einem der Ansprüche 1 bis 3, **dadurch gekennzeichnet, dass** die Seitenwände (9) parallel zu einer Haupterstreckungsrichtung des Durchbrennbereichs (3) angeordnet sind.

5. Leiterbahnsicherung (1) nach einem der vorhergehenden Ansprüche, **dadurch gekennzeichnet, dass** der Durchbrennbereich (3) einen gegenüber dem ersten und zweiten Anschlussbereich (2a,2b) reduzierten Querschnitt (d') aufweist.

6. Leiterbahnsicherung (1) nach einem der vorhergehenden Ansprüche, **dadurch gekennzeichnet, dass** das Abdeckungselement (5) mit den zumindest zwei Seitenwänden (9) homogen ausgebildet ist und eine konstante Dicke (t) aufweist.

7. Leiterbahnsicherung (1) nach einem der vorhergehenden Ansprüche, **dadurch gekennzeichnet, dass** das Abdeckungselement (5) eine gegenüber der Entgasungsöffnung (10) angeordnete Begrenzungswand (11) aufweist, die derart angeordnet ist, dass sie die beiden Seitenwände (9) an einem Ende des Abdeckungselementes (5) verbindet.

8. Leiterbahnsicherung (1) nach einem der vorhergehenden Ansprüche, **dadurch gekennzeichnet, dass** der Durchbrennbereich (3) ein unverzinnter Kupferleiter ist.

9. Leiterplatte (20) aufweisend eine Leiterbahnsicherung (1) gemäß einem der Ansprüche 1 bis 8.

10. Leiterplatte (20) nach Anspruch 9, **dadurch gekennzeichnet, dass** das Abdeckungselement (5) mit der Unterseite der Seitenwände (9) an der Leiterplatte (20) befestige ist und vorzugsweise mittels eines Verbindungselementes (4) verbunden ist.

11. Leiterplatte (20) nach Anspruch 10, **dadurch gekennzeichnet, dass** das Verbindungselement (4) ein Balken oder Streifen aus nichtleitendem Material, vorzugsweise SMD-Kleber oder Lötstopplack ist.

12. Leiterplatte (20) nach einem der Ansprüche 10 bis 11, **dadurch gekennzeichnet, dass** das Verbindungselement (4) mit Hilfe einer Schablone auftragbar ist.

13. Betriebsgerät für Leuchtmittel aufweisend eine Leiterbahnsicherung (1) gemäß einem der Ansprüche 1 bis 8 und eine Leiterplatte (20) nach einem der Ansprüche 9 bis 12.

## Claims

1. Conducting track fuse (1) for an electrical or electronic device, comprising a first and a second connection region (2a, 2b), a linearly or non-linearly extending burn-out region (3) arranged between the first and the second connection region (2a, 2b), and a covering element (5) having at least two lateral walls (9) and a covering surface (8), which covering element is arranged over the first and the second connection region (2a, 2b) and over the burn-out region (3), the burn-out region (3) and the covering element (5) being arranged relative to one another in such a way that the area of the covering surface (8) covers the burn-out region (3) and a cavity (7) is formed between the burn-out region (3) and the covering surface (8) as a result of the height of the lateral walls (9), **characterized in that**
the covering element (5) is designed in such a way that the lateral walls (9) do not completely surround the cavity (7), so that, in plan view of the conducting track fuse, a gas vent (10) is formed on an end face of the covering element (5).

2. Conducting track fuse (1) according to claim 1, **characterized in that** the burn-out region (3) has a zigzag-shaped profile in plan view.

3. Conducting track fuse (1) according to claim 1, **characterized in that** the burn-out region (3) has an at least partially curved or angular profile in plan view.

4. Conducting track fuse (1) according to any of claims 1 to 3, **characterized in that** the lateral walls (9) are arranged parallel to a main extension direction of the burn-out region (3).

5. Conducting track fuse (1) according to any of the preceding claims, **characterized in that** the burn-out region (3) has a reduced cross-section (d') compared to the first and the second connection region (2a, 2b).

6. Conducting track fuse (1) according to any of the preceding claims, **characterized in that** the covering element (5) having the at least two lateral walls (9) is homogeneous and has a constant thickness (t).

7. Conducting track fuse (1) according to any of the preceding claims, **characterized in that** the covering element (5) comprises a delimiting wall (11) arranged opposite the gas vent (10) in such a way that it connects the two lateral walls (9) at one end of the covering element (5).

8. Conducting track fuse (1) according to any of the preceding claims, **characterized in that** the burn-out region (3) is a non-tinned copper conductor.

9. Printed circuit board (20) comprising a conducting track fuse (1) according to any of claims 1 to 8.

10. Printed circuit board (20) according to claim 9, **characterized in that** the covering element (5) is fastened to the printed circuit board (20) via the underside of the lateral walls (9) and is preferably connected by means of a connecting element (4).

11. Printed circuit board (20) according to claim 10, **characterized in that** the connecting element (4) is a bar or strip of non-conductive material, preferably SMD adhesive or solder resist.

12. Printed circuit board (20) according to either claim 10 or claim 11, **characterized in that** the connecting element (4) can be applied using a template.

13. Operating device for lighting means comprising a conducting track fuse (1) according to any of claims 1 to 8 and a printed circuit board (20) according to any of claims 9 to 12.

## Revendications

1. Fusible pour piste conductrice (1) destiné à un appareil électrique ou électronique, présentant une première et une seconde zone de connexion (2a, 2b), une zone de fusion (3) s'étendant linéairement ou non linéairement et agencée entre la première et la seconde zone de connexion (2a, 2b), et un élément de recouvrement (5) comportant au moins deux parois latérales (9) et une surface de recouvrement (8), laquelle est agencée sur la première et la seconde zone de connexion (2a, 2b) et la zone de fusion (3), la zone de fusion (3) et l'élément de recouvrement (5) étant agencés l'un par rapport à l'autre de telle sorte que la surface de la surface de recouvrement (8) recouvre la zone de fusion (3) et qu'un espace creux (7) est formé par la hauteur des parois latérales (9) entre la zone de fusion (3) et la surface de recouvrement (8), **caractérisé en ce**
**que** l'élément de recouvrement (5) est réalisé de telle sorte que les parois latérales (9) n'entourent pas complètement l'espace creux (7), de sorte que, en vue de dessus du fusible pour piste conductrice, une ouverture de dégazage (10) est formée sur une face frontale de l'élément de recouvrement (5).

2. Fusible pour piste conductrice (1) selon la revendication 1,
**caractérisé en ce que** la zone de fusion (3) présente, en vue de dessus, un tracé en zigzag.

3. Fusible pour piste conductrice (1) selon la revendication 1,
**caractérisé en ce que** la zone de fusion (3) présente, en vue de dessus, un tracé au moins partiellement courbé ou anguleux.

4. Fusible pour piste conductrice (1) selon l'une des revendications 1 à 3, **caractérisé en ce que** les parois latérales (9) sont agencées parallèlement à une direction d'extension principale de la zone de fusion (3).

5. Fusible pour piste conductrice (1) selon l'une des revendications précédentes, **caractérisé en ce que** la zone de fusion (3) présente une section transversale (d') réduite par rapport à la première et à la seconde zone de connexion (2a, 2b).

6. Fusible pour piste conductrice (1) selon l'une des revendications précédentes, **caractérisé en ce que** l'élément de recouvrement (5) est réalisé de manière homogène avec les au moins deux parois latérales (9) et présente une épaisseur (t) constante.

7. Fusible pour piste conductrice (1) selon l'une des revendications précédentes, **caractérisé en ce que** l'élément de recouvrement (5) présente une paroi de délimitation (11) agencée à l'opposé de l'ouverture de dégazage (10) et agencée de telle sorte qu'elle relie les deux parois latérales (9) au niveau d'une extrémité de l'élément de recouvrement (5).

8. Fusible pour piste conductrice (1) selon l'une des revendications précédentes, **caractérisé en ce que** la zone de fusion (3) est un conducteur en cuivre non étamé.

9. Carte de circuit imprimé (20) présentant un fusible pour piste conductrice (1) selon l'une des revendications 1 à 8.

10. Carte de circuit imprimé (20) selon la revendication 9, **caractérisée en ce que** l'élément de recouvrement (5) est fixé à la carte de circuit imprimé (20) par la face inférieure des parois latérales (9) et est de préférence relié au moyen d'un élément de liaison (4).

11. Carte de circuit imprimé (20) selon la revendication 10, **caractérisée en ce que** l'élément de liaison (4) est une barre ou une bande en matériau non conducteur, de préférence un adhésif CMS ou une réserve de soudure.

12. Carte de circuit imprimé (20) selon l'une des revendications 10 à 11, **caractérisée en ce que** l'élément de liaison (4) peut être appliqué à l'aide d'un gabarit.

13. Appareil de fonctionnement pour moyens lumineux présentant un fusible pour piste conductrice (1) selon l'une des revendications 1 à 8 et une carte de circuit imprimé (20) selon l'une des revendications 9 à 12.
